# EUROPEAN PATENT SPECIFICATION

(11) **EP 4 111 222 B1**
(45) Date of publication and mention of the grant of the patent: **11.11.2026**
(21) Application number: 21709109.9
(22) Date of filing: 22.02.2021
(51) Int. Cl.: G01R 35/00, G01R 31/36, G01R 31/385, G01R 31/389

(54) **QUALITY CONTROL SYSTEM AND METHOD FOR ELECTRIC BATTERY CELLS**
SYSTEM UND VERFAHREN ZUR QUALITÄTSKONTROLLE ELEKTRISCHER BATTERIEZELLEN
SYSTÈME ET PROCÉDÉ DE CONTRÔLE DE QUALITÉ DE CELLULES ÉLECTRIQUES DE BATTERIE

(30) Priority: 24.02.2020 IT 202000003787
(43) Date of publication of application: 04.01.2023
(73) Proprietor: Comau S.p.A., 10095 Grugliasco (Torino) (IT)
(72) Inventor: TOMASI, Daniele, 10095 Grugliasco (Torino) (IT)
(74) Representative: Buzzi, Notaro & Antonielli d'Oulx S.p.A.
(86) International application number: PCT/IB2021/051473
(87) International publication number: WO 2021/171162

(56) References cited:
- JP-A- 2014 071 074
- US-A1- 2016 291 080

## Description

### Field of the invention

The present invention relates to electric batteries and, in particular, to methods and systems for assembling these batteries.

In an assembly plant for electric batteries, an assembly line is typically provided including a station that receives battery cells or modules to be assembled together, with which a measuring apparatus is associated, for measuring the electrical resistance of a battery cell or battery module and of the open circuit voltage (OCV) supplied by a battery cell or battery module. The measuring apparatus can be arranged to check, continuously or with a determined periodicity, that the battery cells received in the assembly plant correspond to the nominal values prescribed for their inner electrical resistance and for the electrical voltage at the ends of the battery cell.

### Prior art

In assembly plants of the type described above, it is also necessary to check the correct operation of the aforesaid measuring apparatus with a determined periodicity. Currently, this verification would involve the transfer of the measuring apparatus to a specialized laboratory, and a consequent interruption in the production cycle, even only for replacing the measuring apparatus and/or a temporary interruption in the verification procedure.

US 2016/0291080 A1 discloses an automatic test system that includes a battery formation apparatus designed to charge and discharge the batteries and a test fixture that includes a control module, a measurement module and a wireless connection interface, which enables a simulation of the operation of charging and discharging the batteries.

Document JP 2014071074 A also discloses a simulation system of the battery charging and discharging operation, connected via a LAN to the battery testing equipment. Both solutions are quite complex and expensive.

### Object of the invention

Therefore, one object of the present invention is to overcome the drawbacks explained above, by providing a method and a system for controlling the quality of battery cells or battery modules used in a battery assembly plant, wherein the correct operation of the aforesaid measuring apparatus can be checked quickly and easily, without the need to remove the measuring apparatus from the assembly plant.

Another object of the invention is to allow carrying out the aforesaid verification of the correct operation of the measuring apparatus in an extremely precise and reliable way.

### Summary of the invention

With a view to achieving the aforesaid object, the present invention relates to a method and a system for the quality control of electric battery cells or battery modules according to claims 1 and 5.

Further preferred features of the invention are indicated in the dependent claims.

The invention is equally applicable not only to battery cells, but also to entire battery modules consisting of several battery cells assembled together. In this case, the provided measuring apparatus is intended to test an entire battery module, and the method and the system according to the invention envisage arranging dummy battery modules, instead of dummy cells.

As is evident from above, the invention is mainly based on the idea of providing a dummy battery cell that can be used as a gauge to quickly and accurately check the correct operation of the measuring apparatus of the electrical resistance and voltage of the battery cells in a battery assembly plant.

### Detailed description of preferred embodiments

Further characteristics and advantages of the present invention will become apparent from the description that follows with reference to the attached drawings, provided purely by way of non-limiting example, wherein:
Figure 1 is a schematic perspective view illustrating a battery pack for an electric traction vehicle, consisting of a plurality of battery modules, each module - in turn - consisting of a plurality of side-by-side battery cells,

- Figure 2 is a perspective view on an enlarged scale of a single battery cell, of the so-called "pouch" type used in the example of Figure 1,
- Figure 3 is a schematic plan view of an assembly plant for motor-vehicle batteries,
- Figure 4 is a schematic view of a measuring apparatus used in the plant of Figure 3,
- Figures 5, 6 are schematic plan views of two different types of dummy battery cells used in the system and method according to the invention, and
- Figures 7A, 7B are two perspective views of a variant of the dummy cell, which comprises on its two opposite faces both the first electrical circuit with the resistance of a predetermined value, and the second electrical circuit with the voltage generator to generate a voltage of predetermined value.

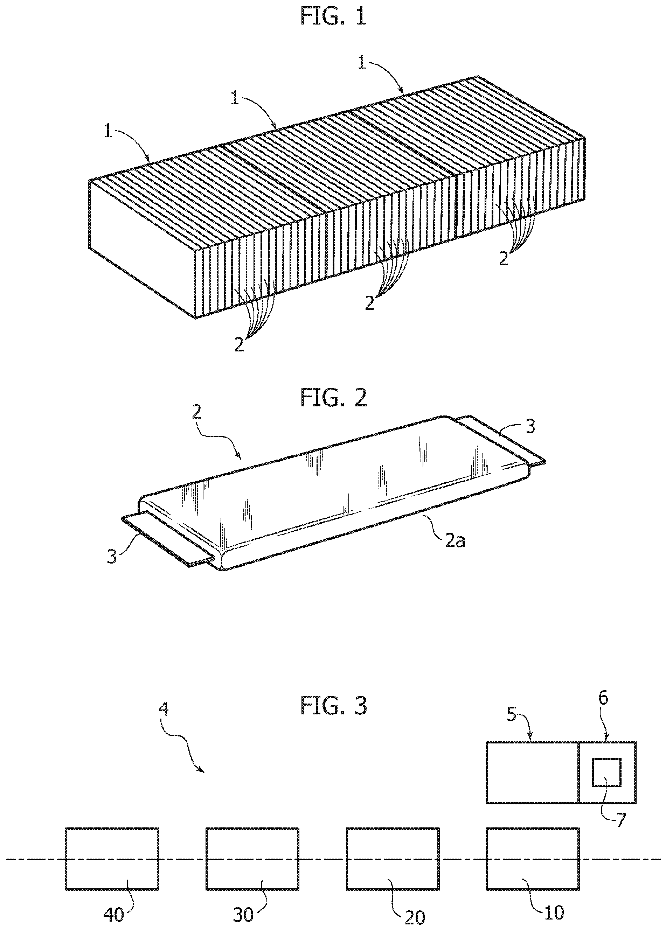

Figure 1 of the attached drawings shows in an extremely schematic way the main part constituting a battery pack, in the example a battery pack for an electric traction vehicle. Figure 1 does not show the battery pack casing or all the devices that are normally associated therewith, including the devices for thermal conditioning of the battery pack. The figure instead shows only the essential components which, in the example, include three side-by-side battery modules 1, each consisting of a plurality of battery cells 2 of the so-called "pouch" type, which is illustrated in perspective view and on an enlarged scale in Figure 2.

Again, Figure 1 does not show the construction details of the battery pack including, among other things, sheets (for example of aluminum) interposed between battery cells or between groups of battery cells, as well as the conductive bars that connect the terminals of the various cells.

Figure 2 is a perspective view of a battery cell of the "pouch" type typically having an elongated and flattened configuration, with a casing 2a, for example, of aluminum, which hermetically wraps the parts making up the cell 2, and a pair of electrical terminals 3. In the illustrated example, the electrical terminals 3 are provided at the two opposite ends of the cell 2, but battery cells can also be used that provide both terminals at the same end of the cell.

It should also be noted that although the attached drawings show an example of application of the invention with reference to battery cells of the "pouch" type, the disclosures of the present invention are immediately applicable to battery cells or modules of any known type, for example, also to battery cells having a cylindrical configuration.

Figure 3 of the attached drawings is a schematic plan view of a plant 4 for assembling battery packs. The plant 4 includes an assembly line including a plurality of stations 10, 20, 30, 40 through which an assembly line of the battery pack extends. A station 5 is arranged adjacent to an initial station 10 of the plant 4, which receives battery cells or modules to be assembled together. The station 5 is associated with a structure 6 carrying an apparatus 7 for measuring the resistance and the open circuit voltage (OCV) of the battery cells arriving at the station 5 to be assembled in the plant 4. The measuring apparatus 7 can be used continuously or with any desired periodicity to check the quality of the battery cells which are assembled.

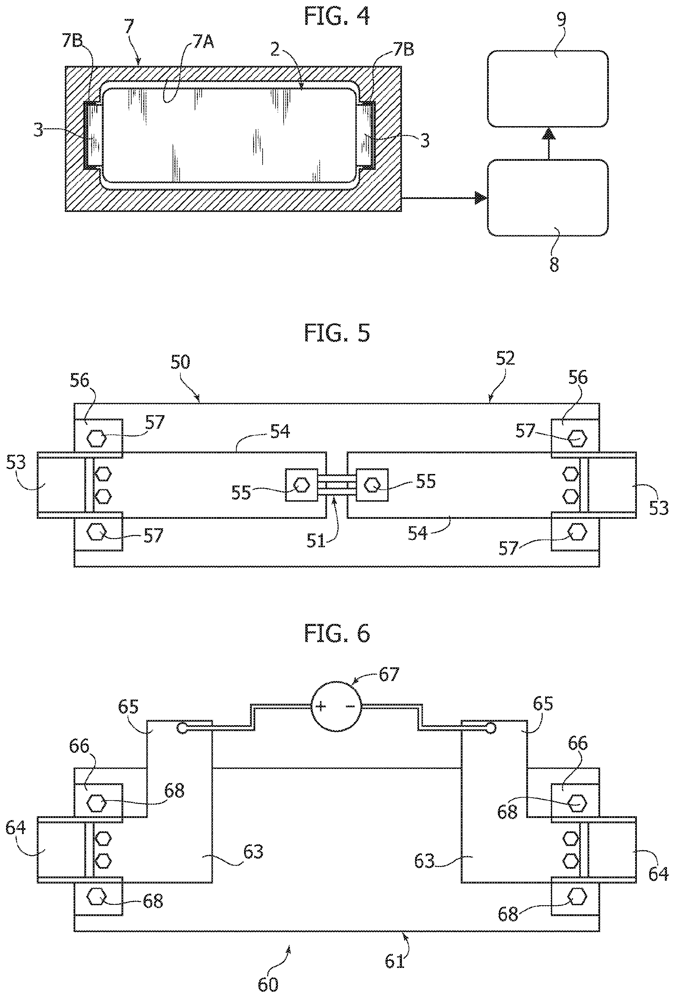

Figure 4 is a schematic view of the measuring apparatus 7. The construction details of this apparatus are not described here, both because this measuring apparatus can be of any known commercially available type and because elimination of these details makes the drawings more ready and easy to understand, and in that the aforesaid manufacturing details of the measuring apparatus, taken on their own, do not form the subject of the present invention.

What is important to note is that the measuring apparatus 7 is arranged with a seat 7A intended to receive a battery cell 2 for checking its electrical resistance and electrical voltage characteristics. Figure 4 shows a battery cell 2 received within the seat 7A of the measuring apparatus 7. The seat 7A is configured and sized in such a way as to be able to accommodate the battery cell 2, and has electrical terminals 7B at the two opposite ends of the seat intended to enter into electrical connection with the terminals 3 of the battery cell 2 when this is received within the location of the measuring apparatus 7. The measuring apparatus 7 is arranged, in a per se known manner, with an electrical measuring circuit, which is capable of sending a signal to an electronic board 8, which is part of the measuring apparatus 7 that processes this signal, to record and display the measured values of electrical resistance and voltage on a display 9. As already indicated, the aforesaid characteristics of the measuring apparatus are described here in a purely schematic way solely for the object of facilitating the understanding of the present invention, being evident that in practice, the conformation of the measuring apparatus 7, per se known, may widely vary with respect to what is described with reference to Figure 4.

As has already been illustrated above, the measuring apparatus 7 allows quality control of the battery cells that arrive at the station 5 to be assembled in the plant 4, but there is the problem of periodically checking the correct operation of the measuring apparatus.

In order to be able to carry out this check in a simple and rapid way, without removing the measuring apparatus 7 from the assembly plant, the invention proposes providing one or more dummy battery cells, to be used as gauges to check the correct operation of the measuring equipment 7.

In a first embodiment, at least two different types of dummy cells are provided, of which Figures 5, 6 show two examples, intended to be used to check the correct operation of the measuring apparatus, respectively, with reference to the resistance measurement and voltage measurement.

The aforesaid dummy battery cells are configured and sized to emulate the shape and dimensions of a real battery cell 2, so that they can be received in the seat 7A of the measuring apparatus 7. A first type of dummy cell, illustrated in Figure 5, is arranged in such a way as to present an electrical resistance of a strictly predetermined value. A second type of dummy cell, illustrated in Figure 6, is provided with a voltage generator which, when activated, produces an electrical voltage of a strictly predetermined value at the terminals of the dummy cell. In this way, each dummy cell may be used as a gauge, placing it in the seat 7A of the measuring apparatus 7, and verifying that the values measured by the apparatus correspond to the known values of the resistance and voltage of the dummy cells, within a margin of predetermined tolerance.

Therefore, verifying the correct operation of the measuring apparatus can be carried out very quickly and in a very simple way, without the need to remove the measuring apparatus from the assembly plant and without causing any interruption or slowing-down compared to the normal productive cycle.

With reference to Figure 5, the reference number 50 indicates - in its entirety - a dummy battery cell arranged with a resistor 51 having a strictly predetermined electrical resistance value. The dummy battery cell 50 comprises a support structure 52 of an electrically non-conductive material, for example, plastic material, with a configuration and general dimensions corresponding to the configuration and dimensions of a single battery cell 2. The support structure 52, therefore, has a relatively elongated and flattened structure, with opposite ends from which electrical terminals 53 protrude. The terminals 53 consist of the ends of metal sheets 54 secured on the upper surface of the support structure 52 in any known way (for example, by means of screws), and terminating at a short distance from each other at the center of the support structure 52. The opposite ends of the resistor 51 are fixed over the adjacent ends of the two sheets 54 by means of screws 55. In the case of the illustrated example, the resistor 51 has a body with two end plates joined together by two cylindrical bars. However, this configuration is provided here purely by way of example. The opposite ends of the sheets 54 rest on the support structure 52 with the interposition of auxiliary support structures 56 fixed to the support structure 52 by screws 57. All of the aforesaid construction details are, of course, given here purely by way of example.

In the case of the aforesaid first embodiment of the invention, which provides a first dummy cell for checking the resistance measurement, and a second dummy cell for checking the voltage measurement, two types of first dummy cells 50 are preferably arranged of the type illustrated in Figure 5, having two different strictly predetermined values of their electrical resistance. The first strictly predetermined value is chosen within the range of acceptability for the electrical resistance of the battery cells to be assembled in the plant 4. The second value is chosen above the aforesaid acceptability range.

Therefore, when it is necessary to verify the correct operation of the measuring apparatus 7 with reference to the measurement of the electrical resistance of the battery cells, the two dummy cells 50 having the two different strictly predetermined values of the electrical resistance are arranged, in successive steps within the seat 7A of the measuring apparatus 7. This procedure is chosen to make the verification of the correct operation of the measuring apparatus more reliable, taking into account the fact that the order of magnitude of the electrical resistance of a battery cell is very small, in the order of a few milli-ohm (for example 6 mΩ).

With reference to Figure 6, the number 60 indicates - in its entirety - a dummy battery cell that can be used to verify the correct operation of the measuring apparatus 7 with reference to the measurement of the open circuit voltage (OCV) of the battery cells. To this end, the dummy battery cell 60 comprises a support structure 61, which, as in the case of the example of Figure 5, is configured and sized in order to emulate the configuration and dimensions of a battery cell 2. The support structure 61 also, therefore, has a substantially flattened and elongated body and is constituted by an electrically non-conducting material, for example, plastic material. Similarly to what is illustrated with reference to Figure 5, also in the case of the dummy cell 60 two metal sheets 63 are secured above the support structure 61 (which in this example have a square configuration), each having a first end 64 and a second end 65. The first ends 64 of the two sheets 63 define opposite electrical terminals of the dummy cell 60, intended to emulate the opposite terminals of a real battery cell. Also in this case, additional supports of plastic material 66 are associated with the ends 64 of the sheets 63, fixed by means of screws 68 to the support structure 61.

The opposite ends of a voltage generator 67 (schematically illustrated in Figure 6) are connected to the ends 65 of the sheets 63, which can be activated to generate an open circuit voltage (OCV) of strictly predetermined value at the terminals 64.

The construction details of the voltage generator 67 are not described or illustrated here, since this generator can be of any known type available on the market, and since it does not fall, taken alone, within the scope of the present invention.

When it is necessary to verify the correct operation of the measuring apparatus 7 with reference to the measurement of the open circuit voltage (OCV) of the battery cells, the dummy battery cell 60 is placed in the seat 7A of the measuring apparatus 7, and the generator 67 is activated to generate a voltage of a strictly predetermined value at the terminals of the dummy cell. It is thus possible to check whether the value measured by the apparatus 7 corresponds to the actual value of the voltage associated with the dummy cell 60.

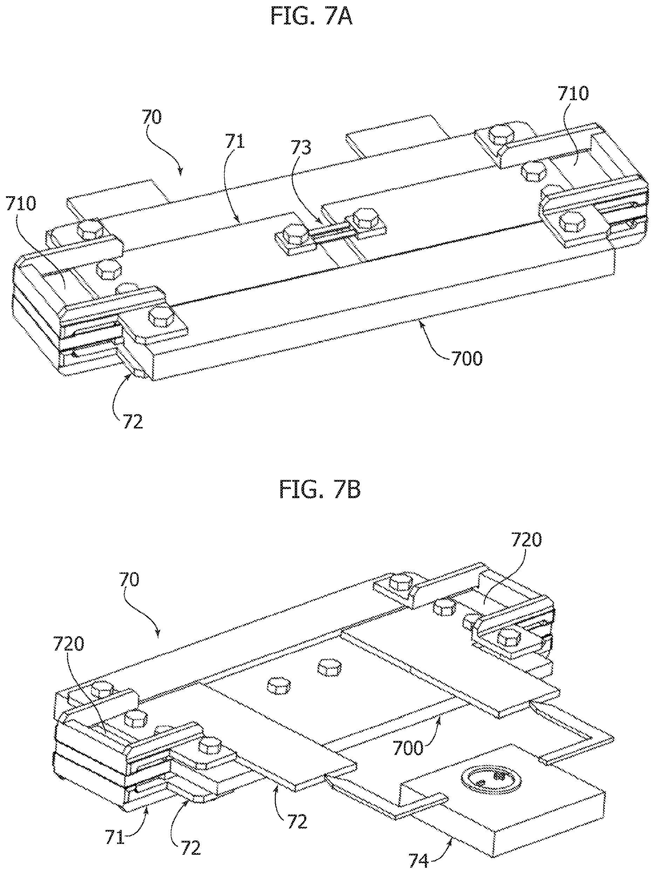

A second embodiment of the invention envisages the provision of a single dummy cell (of which Figures 7A, 7B show a non-limiting example) including, preferably on its two opposite faces, both a first electrical circuit comprising a resistor of a strictly predetermined value, and a second electrical circuit with a voltage generator configured to generate a voltage of a strictly predetermined value. Figures 7A, 7B show the two opposite faces of the same dummy cell 70. The dummy cell 70 has a support structure 700 of an electrically-insulating plastic material, on the two opposite faces a first electric circuit 71, with a resistance 73 of a strictly predetermined value, and a second electric circuit 72, with which the voltage generator 74 is associated, are arranged, configured to generate an electrical voltage of a strictly predetermined value. The two circuits 71, 72 have respective electrical terminals 710, 720, which are separated and insulated from each other, being arranged on the opposite faces of the support structure 700 of insulating material. The dummy cell 70 is arranged oriented as in Figure 7A or as in Figure 7B above the measuring apparatus, depending on whether this apparatus is required for testing with reference to the resistance measurement or voltage measurement.

As is evident from the above description, the idea underlying the present invention is that of providing at least one dummy battery cell, having configuration and dimensions that emulate the configuration and dimensions of a real battery cell, and which can be used as a gauge to check the correct operation of a device for measuring the resistance and/or voltage of the battery cells, since a rigorously predetermined and known resistance value and/or voltage value is associated with this dummy cell.

Of course, without prejudice to the principle of the invention, the details of construction and the embodiments may vary widely with respect to those described and illustrated purely by way of example, without departing from the scope of the present invention, as defined by the attached claims.

## Claims

1. A method for the quality control of electric battery cells or battery modules (2) in a plant (4) for assembling electric batteries,
wherein said plant comprises a battery assembly line (10-40), including a station (5) which is configured for receiving battery cells or battery modules (2) to be assembled together, with which station (5) a measuring apparatus (7) is associated, for measuring the electrical resistance of the battery cell (2),
wherein said measuring apparatus (7) is configured and sized to receive the battery cell (2), and is provided with terminals (7B) configured and arranged to enter into electrical connection with the terminals (3) of the battery cell (2) when the battery cell is received on said measuring apparatus (7),
wherein the correct functionality of said measuring apparatus (7) is verified by arranging at least one dummy battery cell (50, 60) in the measuring apparatus (7), the at least one dummy battery cell having a support structure (52; 61) of electrically non conducting material, configured and sized in order to emulate the configuration and dimensions of a battery cell (2) and configured to be received within the measuring apparatus (7), said at least one dummy battery cell having electrical terminals (53, 64) configured and sized to enter into electrical connection with the terminals (7B) of the measuring apparatus (7) when the at least one dummy battery cell (50, 60) is received in the measuring apparatus (7), and
**characterised in that** said dummy battery cell (50, 60) has a resistor (51) between its terminals (53) with an electrical resistance having a strictly predetermined value,
so that the correct functionality of the measuring apparatus (7) is verified by checking that the resistance measured by the measuring apparatus (7), when said dummy battery cell (50, 60) is received therein, corresponds to said predetermined value, within a given tolerance margin.

2. A method according to claim 1, **characterized in that** said at least one dummy battery cell includes:
- a first dummy battery cell (50) having the electrical resistance between its terminals (53) of strictly predetermined value, and
- a second dummy battery cell (60) including a voltage generator (67) configured to produce a voltage of strictly predetermined value between the terminals (64) of said second dummy battery cell (60),
so that the correct functionality of the measuring apparatus (7) is verified by checking that the resistance and voltage, respectively, measured by the measuring apparatus (7), when said first and second dummy battery cells (50,60) are arranged therein, correspond to said predetermined values, within a given tolerance margin, respectively.

3. A method according to claim 1, **characterized in that** said at least one dummy battery cell includes a single dummy battery cell (70), including a first electric circuit (71) and a second electric circuit (72) having respective pairs of terminals (710, 720), separated from each other,
- wherein said first electric circuit (71) includes the electrical resistance (73) of a strictly predetermined value between the two terminals (710) of the first electric circuit, and
- wherein said second electric circuit (720) includes a voltage generator (74) configured to produce a voltage of strictly predetermined value between the two terminals (720) of said second electric circuit (72),
so that the correct functionality of the measuring apparatus (7) is verified by checking that the resistance and voltage measured by the measuring apparatus (7), when it is connected, respectively, to said first electric circuit (71) and to said second electric circuit (72) of said dummy battery cell (70), correspond to said predetermined values, within a given tolerance margin, respectively.

4. A method according to claim 2, **characterized in that** two first dummy battery cells (50) are provided, which differ from each other by the value of their electrical resistance, the two electrical resistance values of said two first dummy battery cells (50) being: one within the range of acceptability for the electrical resistance of each battery cell (2) and the other above said range of acceptability, and **in that** said measuring apparatus (7) is verified by arranging therein, in successive steps, each of the first two dummy battery cells (50) and said second dummy battery cell (60).

5. A quality control system for electric battery cells or battery modules (2) including a plant (4) for assembling electric batteries,
wherein said plant (4) comprises a battery assembly line (10-40), including a station (5) which is configured to receive battery cells or battery modules (2) to be assembled together, with which station (5) a measuring apparatus (7) is associated, for measuring the electrical resistance of the battery cell (2),
wherein said measuring apparatus (7) is configured and sized to receive the battery cell (2), and is provided with terminals (7B) configured and arranged to enter into electrical connection with the terminals (3) of the battery cell (2) when the battery cell is received within the measuring apparatus,
said system comprising at least one dummy battery cell (50, 60), having a support structure (52; 61) of electrically non-conducting material, configured and sized in order to emulate the configuration and dimensions of a battery cell (2) and to be received within said measuring apparatus (7) and electric terminals (53, 64) configured and sized for entering into electrical connection with the terminals (7B) of the measuring apparatus (7) when the dummy battery cell (50, 60) is received within the measuring apparatus, and
**characterised in that** said at least one dummy battery cell (50, 60) has a resistor (51) between its terminals (53) with an electrical resistance having a strictly predetermined value,
so that the system is configured such that the correct functionality of the measuring apparatus (7) can be verified by checking that the resistance measured by the measuring apparatus (7), when said at least one dummy battery cell (50, 60) is received therein, corresponds to said predetermined value, within a given tolerance margin.

6. A system according to claim 5, **characterized in that** said at least one dummy battery cell comprises:
- a first dummy battery cell (50) having the electrical resistance between its terminals (53) of strictly predetermined value, and
- a second dummy battery cell (60) including a voltage generator (67) configured to produce a voltage of strictly predetermined value between two terminals (64) of said second dummy battery cell (60),
so that the system is configured such that the correct functionality of the measuring apparatus (7) can be verified by checking that the resistance and the voltage measured by the measuring apparatus (7), when said first and second dummy battery cells (50, 60) are received therein, correspond to said predetermined values, within a given tolerance margin.

7. A system according to claim 5, **characterized in that** said at least one dummy battery cell comprises a single dummy battery cell (70), including a first electric circuit (71) and a second electric circuit (72) having respective pairs of terminals (710, 720), separated from each other,
- wherein said first electric circuit (71) includes the electrical resistance (73) of strictly predetermined value between the two terminals (710) of the first electric circuit, and
- wherein said second electric circuit (720) includes a voltage generator (74) configured to produce a voltage of strictly predetermined value between the two terminals (720) of said second electric circuit (72),
so that the system is configured such that the correct functionality of the measuring apparatus (7) can be verified by checking that the resistance and voltage measured by the measuring apparatus (7), when it is connected, respectively, to said first electric circuit (71) and to said second electric circuit (72) of said dummy battery cell (70), correspond to said predetermined values, within a given tolerance margin.

8. A system according to claim 6, **characterized in that** it comprises two first dummy battery cells (50), which differ from each other by the value of their electrical resistance, the two electrical resistance values of said two first dummy battery cells (50) being: one within the range of acceptability for the electrical resistance of each battery cell (2) and the other above said range of acceptability, so that the system is configured such that said measuring apparatus (7) is to be verified by arranging therein, in successive steps, each of the two first dummy battery cells (50) and said second dummy battery cell (60).

## Patentansprüche

1. Verfahren zur Qualitätskontrolle von elektrischen Batteriezellen oder Batteriemodulen (2) in einer Anlage (4) zur Montage von elektrischen Batterien,
wobei besagte Anlage eine Batteriemontagelinie (10-40) umfasst, die eine Station (5) einschließt, welche konfiguriert ist, um zusammenzubauende Batteriezellen oder Batteriemodule (2) aufzunehmen, wobei mit dieser Station (5) eine Messvorrichtung (7) zum Messen des elektrischen Widerstands der Batteriezelle (2) verbunden ist,
wobei besagte Messvorrichtung (7) konfiguriert und dimensioniert ist, um die Batteriezelle (2) aufzunehmen, und mit Anschlüssen (7B) versehen ist, die konfiguriert und angeordnet sind, um in elektrische Verbindung mit den Anschlüssen (3) der Batteriezelle (2) zu treten, wenn die Batteriezelle auf besagter Messvorrichtung (7) aufgenommen ist,
wobei die korrekte Funktionalität besagter Messvorrichtung (7) verifiziert wird, indem mindestens eine Dummy-Batteriezelle (50, 60) in der Messvorrichtung (7) angeordnet wird, wobei die mindestens eine Dummy-Batteriezelle eine Trägerstruktur (52; 61) aus elektrisch nicht leitendem Material aufweist, die konfiguriert und dimensioniert ist, um die Konfiguration und Abmessungen einer Batteriezelle (2) nachzubilden, und konfiguriert ist, um innerhalb der Messvorrichtung (7) aufgenommen zu werden, wobei besagte mindestens eine Dummy-Batteriezelle elektrische Anschlüsse (53, 64) aufweist, die konfiguriert und dimensioniert sind, um in elektrische Verbindung mit den Anschlüssen (7B) der Messvorrichtung (7) zu treten, wenn die mindestens eine Dummy-Batteriezelle (50, 60) in der Messvorrichtung (7) aufgenommen ist, und
**dadurch gekennzeichnet, dass** besagte Dummy-Batteriezelle (50, 60) einen Widerstand (51) zwischen ihren Anschlüssen (53) mit einem elektrischen Widerstand von streng vorbestimmtem Wert aufweist,
so dass die korrekte Funktionalität der Messvorrichtung (7) verifiziert wird, indem überprüft wird, dass der von der Messvorrichtung (7) gemessene Widerstand, wenn besagte Dummy-Batteriezelle (50, 60) darin aufgenommen ist, innerhalb einer gegebenen Toleranzgrenze besagtem vorbestimmten Wert entspricht.

2. Verfahren nach Anspruch 1, **dadurch gekennzeichnet, dass** besagte mindestens eine Dummy-Batteriezelle umfasst:
- eine erste Dummy-Batteriezelle (50), die den elektrischen Widerstand zwischen ihren Anschlüssen (53) von streng vorbestimmtem Wert aufweist, und
- eine zweite Dummy-Batteriezelle (60), die einen Spannungsgenerator (67) einschließt, der konfiguriert ist, um eine Spannung von streng vorbestimmtem Wert zwischen den Anschlüssen (64) besagter zweiter Dummy-Batteriezelle (60) zu erzeugen,
so dass die korrekte Funktionalität der Messvorrichtung (7) verifiziert wird, indem überprüft wird, dass der Widerstand bzw. die Spannung, gemessen von der Messvorrichtung (7), wenn besagte erste und zweite Dummy-Batteriezellen (50, 60) darin angeordnet sind, jeweils innerhalb einer gegebenen Toleranzgrenze besagten vorbestimmten Werten entsprechen.

3. Verfahren nach Anspruch 1, **dadurch gekennzeichnet, dass** besagte mindestens eine Dummy-Batteriezelle eine einzelne Dummy-Batteriezelle (70) umfasst, die einen ersten elektrischen Schaltkreis (71) und einen zweiten elektrischen Schaltkreis (72) mit jeweiligen, voneinander getrennten Anschlusspaaren (710, 720) einschließt,
- wobei besagter erster elektrischer Schaltkreis (71) den elektrischen Widerstand (73) von streng vorbestimmtem Wert zwischen den zwei Anschlüssen (710) des ersten elektrischen Schaltkreises einschließt, und
- wobei besagter zweiter elektrischer Schaltkreis (720) einen Spannungsgenerator (74) einschließt, der konfiguriert ist, um eine Spannung von streng vorbestimmtem Wert zwischen den zwei Anschlüssen (720) besagten zweiten elektrischen Schaltkreises (72) zu erzeugen,
so dass die korrekte Funktionalität der Messvorrichtung (7) verifiziert wird, indem überprüft wird, dass der Widerstand und die Spannung, gemessen von der Messvorrichtung (7), wenn sie jeweils mit besagtem ersten elektrischen Schaltkreis (71) und mit besagtem zweiten elektrischen Schaltkreis (72) besagter Dummy-Batteriezelle (70) verbunden ist, jeweils innerhalb einer gegebenen Toleranzgrenze besagten vorbestimmten Werten entsprechen.

4. Verfahren nach Anspruch 2, **dadurch gekennzeichnet, dass** zwei erste Dummy-Batteriezellen (50) bereitgestellt werden, die sich voneinander durch den Wert ihres elektrischen Widerstands unterscheiden, wobei die zwei elektrischen Widerstandswerte besagter zwei erster Dummy-Batteriezellen (50) sind: einer innerhalb des Akzeptanzbereichs für den elektrischen Widerstand jeder Batteriezelle (2) und der andere oberhalb besagten Akzeptanzbereichs, und dass besagte Messvorrichtung (7) verifiziert wird, indem darin in aufeinanderfolgenden Schritten jede der ersten zwei Dummy-Batteriezellen (50) und besagte zweite Dummy-Batteriezelle (60) angeordnet werden.

5. Qualitätskontrollsystem für elektrische Batteriezellen oder Batteriemodule (2), das eine Anlage (4) zur Montage von elektrischen Batterien einschließt,
wobei besagte Anlage (4) eine Batteriemontagelinie (10-40) umfasst, die eine Station (5) einschließt, welche konfiguriert ist, um zusammenzubauende Batteriezellen oder Batteriemodule (2) aufzunehmen, wobei mit dieser Station (5) eine Messvorrichtung (7) zum Messen des elektrischen Widerstands der Batteriezelle (2) verbunden ist,
wobei besagte Messvorrichtung (7) konfiguriert und dimensioniert ist, um die Batteriezelle (2) aufzunehmen, und mit Anschlüssen (7B) versehen ist, die konfiguriert und angeordnet sind, um in elektrische Verbindung mit den Anschlüssen (3) der Batteriezelle (2) zu treten, wenn die Batteriezelle innerhalb der Messvorrichtung aufgenommen ist,
besagtes System umfassend mindestens eine Dummy-Batteriezelle (50, 60), die eine Trägerstruktur (52; 61) aus elektrisch nicht leitendem Material aufweist, konfiguriert und dimensioniert, um die Konfiguration und Abmessungen einer Batteriezelle (2) nachzubilden und innerhalb besagter Messvorrichtung (7) aufgenommen zu werden, und elektrische Anschlüsse (53, 64), konfiguriert und dimensioniert, um in elektrische Verbindung mit den Anschlüssen (7B) der Messvorrichtung (7) zu treten, wenn die Dummy-Batteriezelle (50, 60) innerhalb der Messvorrichtung aufgenommen ist, und
**dadurch gekennzeichnet, dass** besagte mindestens eine Dummy-Batteriezelle (50, 60) einen Widerstand (51) zwischen ihren Anschlüssen (53) mit einem elektrischen Widerstand von streng vorbestimmtem Wert aufweist,
so dass das System derart konfiguriert ist, dass die korrekte Funktionalität der Messvorrichtung (7) verifiziert werden kann, indem überprüft wird, dass der von der Messvorrichtung (7) gemessene Widerstand, wenn besagte mindestens eine Dummy-Batteriezelle (50, 60) darin aufgenommen ist, innerhalb einer gegebenen Toleranzgrenze besagtem vorbestimmten Wert entspricht.

6. System nach Anspruch 5, **dadurch gekennzeichnet, dass** besagte mindestens eine Dummy-Batteriezelle umfasst:
- eine erste Dummy-Batteriezelle (50), die den elektrischen Widerstand zwischen ihren Anschlüssen (53) von streng vorbestimmtem Wert aufweist, und
- eine zweite Dummy-Batteriezelle (60), die einen Spannungsgenerator (67) einschließt, der konfiguriert ist, um eine Spannung von streng vorbestimmtem Wert zwischen zwei Anschlüssen (64) besagter zweiter Dummy-Batteriezelle (60) zu erzeugen,
so dass das System derart konfiguriert ist, dass die korrekte Funktionalität der Messvorrichtung (7) verifiziert werden kann, indem überprüft wird, dass der Widerstand und die Spannung, gemessen von der Messvorrichtung (7), wenn besagte erste und zweite Dummy-Batteriezellen (50, 60) darin aufgenommen sind, jeweils innerhalb einer gegebenen Toleranzgrenze besagten vorbestimmten Werten entsprechen.

7. System nach Anspruch 5, **dadurch gekennzeichnet, dass** besagte mindestens eine Dummy-Batteriezelle eine einzelne Dummy-Batteriezelle (70) umfasst, die einen ersten elektrischen Schaltkreis (71) und einen zweiten elektrischen Schaltkreis (72) mit jeweiligen, voneinander getrennten Anschlusspaaren (710, 720) einschließt,
- wobei besagter erster elektrischer Schaltkreis (71) den elektrischen Widerstand (73) von streng vorbestimmtem Wert zwischen den zwei Anschlüssen (710) des ersten elektrischen Schaltkreises einschließt, und
- wobei besagter zweiter elektrischer Schaltkreis (720) einen Spannungsgenerator (74) einschließt, der konfiguriert ist, um eine Spannung von streng vorbestimmtem Wert zwischen den zwei Anschlüssen (720) besagten zweiten elektrischen Schaltkreises (72) zu erzeugen,
so dass das System derart konfiguriert ist, dass die korrekte Funktionalität der Messvorrichtung (7) verifiziert werden kann, indem überprüft wird, dass der Widerstand und die Spannung, gemessen von der Messvorrichtung (7), wenn sie jeweils mit besagtem ersten elektrischen Schaltkreis (71) und mit besagtem zweiten elektrischen Schaltkreis (72) besagter Dummy-Batteriezelle (70) verbunden ist, jeweils innerhalb einer gegebenen Toleranzgrenze besagten vorbestimmten Werten entsprechen.

8. System nach Anspruch 6, **dadurch gekennzeichnet, dass** es zwei erste Dummy-Batteriezellen (50) umfasst, die sich voneinander durch den Wert ihres elektrischen Widerstands unterscheiden, wobei die zwei elektrischen Widerstandswerte besagter zwei erster Dummy-Batteriezellen (50) sind: einer innerhalb des Akzeptanzbereichs für den elektrischen Widerstand jeder Batteriezelle (2) und der andere oberhalb besagten Akzeptanzbereichs, so dass das System derart konfiguriert ist, dass besagte Messvorrichtung (7) zu verifizieren ist, indem darin in aufeinanderfolgenden Schritten jede der zwei ersten Dummy-Batteriezellen (50) und besagte zweite Dummy-Batteriezelle (60) angeordnet werden.

## Revendications

1. Procédé pour le contrôle qualité de cellules de batterie électrique ou de modules de batterie (2) dans une installation (4) pour l'assemblage de batteries électriques,
dans lequel ladite installation comprend une ligne d'assemblage de batteries (10-40), incluant un poste (5) qui est configuré pour recevoir des cellules de batterie ou des modules de batterie (2) à assembler ensemble, poste (5) auquel un appareil de mesure (7) est associé, pour mesurer la résistance électrique de la cellule de batterie (2),
dans lequel ledit appareil de mesure (7) est configuré et dimensionné pour recevoir la cellule de batterie (2), et est muni de bornes (7B) configurées et agencées pour entrer en connexion électrique avec les bornes (3) de la cellule de batterie (2) lorsque la cellule de batterie est reçue sur ledit appareil de mesure (7),
dans lequel la fonctionnalité correcte dudit appareil de mesure (7) est vérifiée en disposant au moins une cellule de batterie factice (50, 60) dans l'appareil de mesure (7), la au moins une cellule de batterie factice ayant une structure de support (52 ; 61) en matériau électriquement non conducteur, configurée et dimensionnée de manière à imiter la configuration et les dimensions d'une cellule de batterie (2) et configurée pour être reçue à l'intérieur de l'appareil de mesure (7), ladite au moins une cellule de batterie factice ayant des bornes électriques (53, 64) configurées et dimensionnées pour entrer en connexion électrique avec les bornes (7B) de l'appareil de mesure (7) lorsque la au moins une cellule de batterie factice (50, 60) est reçue dans l'appareil de mesure (7), et
**caractérisé en ce que** ladite cellule de batterie factice (50, 60) a une résistance (51) entre ses bornes (53) avec une résistance électrique ayant une valeur strictement prédéterminée,
de sorte que la fonctionnalité correcte de l'appareil de mesure (7) est vérifiée en contrôlant que la résistance mesurée par l'appareil de mesure (7), lorsque ladite cellule de batterie factice (50, 60) est reçue à l'intérieur de celui-ci, correspond à ladite valeur prédéterminée, dans une marge de tolérance donnée.

2. Procédé selon la revendication 1, **caractérisé en ce que** ladite au moins une cellule de batterie factice inclut :
- une première cellule de batterie factice (50) ayant la résistance électrique entre ses bornes (53) de valeur strictement prédéterminée, et
- une deuxième cellule de batterie factice (60) incluant un générateur de tension (67) configuré pour produire une tension de valeur strictement prédéterminée entre les bornes (64) de ladite deuxième cellule de batterie factice (60),
de sorte que la fonctionnalité correcte de l'appareil de mesure (7) est vérifiée en contrôlant que la résistance et la tension, respectivement, mesurées par l'appareil de mesure (7), lorsque lesdites première et deuxième cellules de batterie factices (50, 60) sont disposées à l'intérieur de celui-ci, correspondent auxdites valeurs prédéterminées, dans une marge de tolérance donnée, respectivement.

3. Procédé selon la revendication 1, **caractérisé en ce que** ladite au moins une cellule de batterie factice inclut une seule cellule de batterie factice (70), incluant un premier circuit électrique (71) et un deuxième circuit électrique (72) ayant des paires respectives de bornes (710, 720), séparées l'une de l'autre,
- dans lequel ledit premier circuit électrique (71) inclut la résistance électrique (73) d'une valeur strictement prédéterminée entre les deux bornes (710) du premier circuit électrique, et
- dans lequel ledit deuxième circuit électrique (720) inclut un générateur de tension (74) configuré pour produire une tension de valeur strictement prédéterminée entre les deux bornes (720) dudit deuxième circuit électrique (72),
de sorte que la fonctionnalité correcte de l'appareil de mesure (7) est vérifiée en contrôlant que la résistance et la tension mesurées par l'appareil de mesure (7), lorsqu'il est connecté, respectivement, audit premier circuit électrique (71) et audit deuxième circuit électrique (72) de ladite cellule de batterie factice (70), correspondent auxdites valeurs prédéterminées, dans une marge de tolérance donnée, respectivement.

4. Procédé selon la revendication 2, **caractérisé en ce que** deux premières cellules de batterie factices (50) sont prévues, qui diffèrent l'une de l'autre par la valeur de leur résistance électrique, les deux valeurs de résistance électrique desdites deux premières cellules de batterie factices (50) étant : l'une dans la plage d'acceptabilité pour la résistance électrique de chaque cellule de batterie (2) et l'autre au-dessus de ladite plage d'acceptabilité, et **en ce que** ledit appareil de mesure (7) est vérifié en disposant à l'intérieur de celui-ci, dans des étapes successives, chacune des deux premières cellules de batterie factices (50) et ladite deuxième cellule de batterie factice (60).

5. Système de contrôle qualité pour cellules de batterie électrique ou modules de batterie (2) incluant une installation (4) pour l'assemblage de batteries électriques,
dans lequel ladite installation (4) comprend une ligne d'assemblage de batteries (10-40), incluant un poste (5) qui est configuré pour recevoir des cellules de batterie ou des modules de batterie (2) à assembler ensemble, poste (5) auquel un appareil de mesure (7) est associé, pour mesurer la résistance électrique de la cellule de batterie (2),
dans lequel ledit appareil de mesure (7) est configuré et dimensionné pour recevoir la cellule de batterie (2), et est muni de bornes (7B) configurées et agencées pour entrer en connexion électrique avec les bornes (3) de la cellule de batterie (2) lorsque la cellule de batterie est reçue à l'intérieur de l'appareil de mesure,
ledit système comprenant au moins une cellule de batterie factice (50, 60), ayant une structure de support (52 ; 61) en matériau électriquement non conducteur, configurée et dimensionnée de manière à imiter la configuration et les dimensions d'une cellule de batterie (2) et à être reçue à l'intérieur dudit appareil de mesure (7) et des bornes électriques (53, 64) configurées et dimensionnées pour entrer en connexion électrique avec les bornes (7B) de l'appareil de mesure (7) lorsque la cellule de batterie factice (50, 60) est reçue à l'intérieur de l'appareil de mesure, et
**caractérisé en ce que** ladite au moins une cellule de batterie factice (50, 60) a une résistance (51) entre ses bornes (53) avec une résistance électrique ayant une valeur strictement prédéterminée,
de sorte que le système est configuré de telle sorte que la fonctionnalité correcte de l'appareil de mesure (7) peut être vérifiée en contrôlant que la résistance mesurée par l'appareil de mesure (7), lorsque ladite au moins une cellule de batterie factice (50, 60) est reçue à l'intérieur de celui-ci, correspond à ladite valeur prédéterminée, dans une marge de tolérance donnée.

6. Système selon la revendication 5, **caractérisé en ce que** ladite au moins une cellule de batterie factice comprend :
- une première cellule de batterie factice (50) ayant la résistance électrique entre ses bornes (53) de valeur strictement prédéterminée, et
- une deuxième cellule de batterie factice (60) incluant un générateur de tension (67) configuré pour produire une tension de valeur strictement prédéterminée entre deux bornes (64) de ladite deuxième cellule de batterie factice (60),
de sorte que le système est configuré de telle sorte que la fonctionnalité correcte de l'appareil de mesure (7) peut être vérifiée en contrôlant que la résistance et la tension mesurées par l'appareil de mesure (7), lorsque lesdites première et deuxième cellules de batterie factices (50, 60) sont reçues à l'intérieur de celui-ci, correspondent auxdites valeurs prédéterminées, dans une marge de tolérance donnée.

7. Système selon la revendication 5, **caractérisé en ce que** ladite au moins une cellule de batterie factice comprend une seule cellule de batterie factice (70), incluant un premier circuit électrique (71) et un deuxième circuit électrique (72) ayant des paires respectives de bornes (710, 720), séparées l'une de l'autre,
- dans lequel ledit premier circuit électrique (71) inclut la résistance électrique (73) de valeur strictement prédéterminée entre les deux bornes (710) du premier circuit électrique, et
- dans lequel ledit deuxième circuit électrique (720) inclut un générateur de tension (74) configuré pour produire une tension de valeur strictement prédéterminée entre les deux bornes (720) dudit deuxième circuit électrique (72),
de sorte que le système est configuré de telle sorte que la fonctionnalité correcte de l'appareil de mesure (7) peut être vérifiée en contrôlant que la résistance et la tension mesurées par l'appareil de mesure (7), lorsqu'il est connecté, respectivement, audit premier circuit électrique (71) et audit deuxième circuit électrique (72) de ladite cellule de batterie factice (70), correspondent auxdites valeurs prédéterminées, dans une marge de tolérance donnée.

8. Système selon la revendication 6, **caractérisé en ce qu'**il comprend deux premières cellules de batterie factices (50), qui diffèrent l'une de l'autre par la valeur de leur résistance électrique, les deux valeurs de résistance électrique desdites deux premières cellules de batterie factices (50) étant : l'une dans la plage d'acceptabilité pour la résistance électrique de chaque cellule de batterie (2) et l'autre au-dessus de ladite plage d'acceptabilité, de sorte que le système est configuré de telle sorte que ledit appareil de mesure (7) doit être vérifié en disposant à l'intérieur de celui-ci, dans des étapes successives, chacune des deux premières cellules de batterie factices (50) et ladite deuxième cellule de batterie factice (60).
